# EUROPEAN PATENT SPECIFICATION

(11) **EP 4 617 694 B1**
(45) Date of publication and mention of the grant of the patent: **09.12.2026**
(21) Application number: 25161219.8
(22) Date of filing: 03.03.2025
(51) Int. Cl.: G01R 31/396

(54) **METHOD AND SYSTEM FOR DETECTING CONNECTION DEFECTS IN SENSING LINES AND BATTERY PACK INCLUDING THE SAME**
VERFAHREN UND SYSTEM ZUR ERKENNUNG VON VERBINDUNGSDEFEKTEN IN MESSLEITUNGEN UND BATTERIEPACK DAMIT
PROCÉDÉ ET SYSTÈME DE DÉTECTION DE DÉFAUTS DE CONNEXION DANS DES LIGNES DE DÉTECTION ET BLOC-BATTERIE COMPRENANT CEUX-CI

(30) Priority: 05.03.2024 KR 20240031546
(43) Date of publication of application: 17.09.2025
(60) Divisional application: 26186373.2 / 4 790 440
(73) Proprietor: SAMSUNG SDI CO., LTD., Yongin-si, Gyeonggi-do 17084 (KR)
(72) Inventor: YOO, Jae Shik, 17084 Yongin-Si, Gyeonggi-do (KR)
(74) Representative: Michalski Hüttermann & Partner mbB

(56) References cited:
- CN-A- 102 809 708

## Description

### FIELD

Aspects of embodiments of the present disclosure relate to a method and a system for a method for detecting connection defects in sensing lines and a battery pack including the same.

### BACKGROUND

Unlike primary batteries that are not designed to be (re)charged, secondary (or rechargeable) batteries are batteries that are designed to be discharged and recharged. Low-capacity secondary batteries are used in portable, small electronic devices, such as smart phones, feature phones, notebook computers, digital cameras, and camcorders, while large-capacity secondary batteries are widely used as power sources for driving motors in hybrid vehicles and electric vehicles and for storing power (e.g., home and/or utility scale power storage). A secondary battery generally includes an electrode assembly composed of a positive electrode and a negative electrode, a case accommodating the same, and electrode terminals connected to the electrode assembly.

The above information disclosed in this Background section is for enhancement of understanding of the background of the present disclosure, and therefore, it may contain information that does not constitute related (or prior) art.

Document CN 102 809 708 A describes a cell monitoring device, a disconnection detection program and a disconnection detection method of an electricity storage module. In particular, this document describes a technique of wire disconnection which uses a non-conventional scheme to connect various unit cells and a cell monitoring device of a plurality of unit cells. A cell monitoring unit of the cell monitoring device enables a plurality of switches which is parallelly connected with the plurality of cells respectively through voltage measurement wires to be switched from being disconnected to being disconnected again after being switched on in a predetermined sequence.

### SUMMARY

Embodiments of the present disclosure provide a method and system for method for detecting connection defects in sensing lines and battery pack including the same.

These and other aspects and features of the present disclosure will be described in or will be apparent from the following description of embodiments of the present disclosure.

The invention is defined by the features of the independent claims. Preferred embodiments are described by the features of the dependent claims.

The invention is directed to a computer implemented method for detecting a connection defect in a sensing line, the method comprising: receiving a measured overall voltage of a battery pack and a measured voltage of each of a plurality of cell banks included in the battery pack; calculating based on the received overall voltage and the received voltage of each of the plurality of cell banks, a voltage deviation associated with each of the plurality of cell banks; and determining, based on the calculated voltage deviation, one or more connection defects of at least one of a plurality of sensing lines associated with the plurality of cell banks.

Preferably, the step of receiving the measured overall voltage of the battery pack and the measured voltage of each of the plurality of cell banks comprises measuring the overall voltage of the battery pack and the voltage of each of the plurality of cell banks included in the battery pack. Thus, preferably the method for detecting a connection defect in a sensing line includes measuring an overall voltage of a battery pack and a voltage of each of a plurality of cell banks included in the battery pack, calculating, based on the overall voltage and the voltage of each of the plurality of cell banks, a voltage deviation associated with each of the plurality of cell banks, and determining, based on the voltage deviation, one or more connection defects of at least one of a plurality of sensing lines associated with the plurality of cell banks.

According to one embodiment, the determining of the one or more connection defects comprises determining, based on the voltage deviation, that the at least one of the plurality of sensing lines are in a temporary faulty connection state.

According to one embodiment, the determining that the at least one of the plurality of sensing lines are in the temporary faulty connection state comprises determining, based on the voltage deviation and a predetermined first range, a plurality of cell banks associated with the one or more connection defects, and determining a sensing line connected between the determined cell banks to be in the temporary faulty connection state.

According to the invention, the determining of the one or more connection defects comprises calculating, based on the voltage deviation, an amount of change in voltage deviation per unit time for each of the plurality of cell banks, determining, based on the amount of change in voltage deviation and a pattern of the change, a plurality of cell banks associated with the one or more connection defects, and determining whether a sensing line connected between the determined plurality of cell banks has a connection defect.

According to one embodiment, the method further includes activating a temporary failure protection function for the at least one of the plurality of sensing lines determined as being in the temporary faulty connection state.

According to one embodiment, the determining of the one or more connection defects further comprises separately monitoring voltage deviations for a plurality of cell banks associated with the at least one of the plurality of sensing lines determined as being in the temporary faulty connection state.

According to one embodiment, the determining of the one or more connection defects further comprises, determining, based on a predetermined second range and voltage deviations for a plurality of cell banks associated with the at least one of the plurality of sensing lines determined as being in the temporary faulty connection state, that the at least one of the plurality of sensing lines determined as being in the temporary faulty connection state are in a normal connection state.

According to one embodiment, the method further includes interrupting a protection function of the at least one of the plurality of sensing lines determined as being in the normal connection state.

According to one embodiment, the determining of the one or more connection defects further comprises determining the at least one of the plurality of sensing lines determined as being in the temporary faulty connection state to be in a permanent faulty connection state based on voltage deviations of a plurality of cell banks associated with the at least one of the plurality of sensing lines determined as being in the temporary faulty connection state, a predetermined time, and a poor connection condition.

According to one embodiment, the poor connection condition comprises a first condition in which a voltage deviation of a first cell bank associated with one of the at least one of the plurality of sensing lines determined as being in the temporary faulty connection state is increased, and a voltage deviation of a second cell bank connected in series the first cell bank in a positive electrode direction from the first cell bank is decreased; or a second condition in which the voltage deviation of the first cell bank is decreased and the voltage deviation of the second cell bank is increased. Preferably, the voltage deviation is increased or decreased in comparison to the voltage deviation of a cell bank not being associated with one of the at least one of the plurality of sensing lines determined as being in the at least temporary faulty connection state.

According to one embodiment, the method further includes activating a permanent failure protection function for the at least one of the plurality of sensing lines determined as being in the permanent faulty connection state.

According to one embodiment, the method further includes providing data regarding a sensing line determined to have the one or more connection defects and a cell bank associated with the sensing line.

According to one embodiment, the cell bank associated with the sensing line corresponds to a cell bank positioned in a direction toward a negative electrode between a plurality of cell banks associated with the sensing line determined to have the one or more connection defects.

There is provided at least one non-transitory computer-readable storage medium storing instructions for executing the method described above on a computer.

A battery pack of the present disclosure includes a plurality of cell banks connected in series, and a plurality of sensing lines connecting the plurality of cell banks and the battery management system, wherein the battery management system calculates, based on an overall voltage of the battery pack and a voltage of each of the plurality of cell banks, voltage deviations associated with at least some of the plurality of cell banks, and determines, based on the voltage deviations, one or more connection defects in at least one of the plurality of sensing lines associated with the plurality of cell banks, and wherein the battery management system is further configured such that the determining of the one or more connection defects comprises: calculating, based on the calculated voltage deviation, an amount of change in voltage deviation per unit time for each of the plurality of cell banks; determining, based on the calculated amount of change in voltage deviation and a pattern of the change, a plurality of cell banks associated with the one or more connection defects; and determining whether a sensing line connected between the determined plurality of cell banks has a connection defect.

According to one embodiment, the battery management system determines the at least one of the plurality of sensing lines to be in a temporary faulty connection state based on the voltage deviations.

According to one embodiment, the battery management system activates a temporary failure protection function for the at least one of the plurality of sensing lines determined as being in the temporary faulty connection state.

According to one embodiment, the battery management system determines the at least one of the plurality of sensing lines determined as being in the temporary faulty connection state to be in a permanent faulty connection state based on voltage deviations of a plurality of cell banks associated with the at least one of the plurality of sensing lines determined as being in the temporary faulty connection state, a predetermined time, and a poor connection condition.

According to one embodiment, the battery management system activates a permanent failure protection function for the at least one of the plurality of sensing lines determined as being in the permanent faulty connection state.

According to one embodiment, based on a predetermined range and voltage deviations for a plurality of cell banks associated with the at least one of the plurality of sensing lines determined as being in the temporary faulty connection state, the battery management system determines the at least one of the plurality of sensing lines determined as being in the temporary faulty connection state to be in a normal connection state, and discontinues a protection function of the at least one of the plurality of sensing lines determined as being in the normal connection state.

According to some embodiments of the present disclosure, the battery management system may first confirm the connection of sensing lines and activate the temporary failure protection function before determining a cell over voltage failure (COVF), a cell imbalance failure (CIBF) or the like, thereby preventing the permanent failure protection function from being activated due to the connection defects in the sensing lines despite the cells being normal (healthy). Consequently, unnecessary disposal of battery packs containing healthy cells can be prevented, reducing disposal costs and improving the availability of battery packs.

According to some embodiments of the present disclosure, by confirming the recovery of sensing lines temporarily experiencing connection defects, the temporary failure protection function may be discontinued. Consequently, this prevents the permanent failure protection function from being activated even when the connection state of the sensing lines is temporarily imperfect.

According to some embodiments of the present disclosure, the amount of change in voltage deviation can be used to determine the sensing line connection defects. In addition, by using the voltage deviation together with the amount of change in voltage deviation, it is possible to more accurately assess the connection defects in the sensing lines.

Those described above, and other aspects and features not mentioned will be clearly understood by a person skilled in the art from the detailed description, described below.

### BRIEF DESCRIPTION OF THE DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings:
FIG. 1 illustrates an example of a configuration of a battery pack for detecting connection defects in sensing lines according to one embodiment of the present disclosure.
FIG. 2 is a diagram illustrating an example of a method for calculating a voltage deviation according to one embodiment of the present disclosure.
FIG. 3 is a diagram illustrating an example of a method for determining a connection state of a sensing line in accordance with one embodiment of the present disclosure.
FIG. 4 is a diagram illustrating an example of a voltage deviation graph for a simulation in which there are sensing line connection defects according to one embodiment of the present disclosure.
FIG. 5 is a diagram illustrating an example of a voltage deviation graph for a simulation of recovery of the sensing line connection defects according to one embodiment of the present disclosure.
FIG. 6 is a diagram illustrating an example of a method for determining a faulty connection state of a sensing line based on an amount of change in voltage deviation and a pattern of the change according to one embodiment of the present disclosure.
FIG. 7 is a diagram illustrating an example of a method for detecting connection defects in sensing lines based on a display of voltage deviations of cell banks according to one embodiment of the present disclosure.
FIG. 8 is a diagram illustrating an example of a poor connection condition according to one embodiment of the present disclosure.
FIG. 9 is a flowchart illustrating an example of a method for detecting sensing line connection defects according to one embodiment of the present disclosure.

### DETAILED DESCRIPTION

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when a layer or element is referred to as being "between" two layers, it can be the only layer between the two layers, or one or more intervening layers may also be present. It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein. All such ranges are intended to be inherently described in this specification such that amending to expressly recite any such subranges would comply with the requirements of local patent laws.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

Arranging an arbitrary element "above (or below)" or "on (under)" another element may mean that the arbitrary element may be disposed in contact with the upper (or lower) surface of the element, and another element may also be interposed between the element and the arbitrary element disposed on (or under) the element.

In addition, it will be understood that when a component is referred to as being "linked," "coupled," or "connected" to another component, the elements may be directly "coupled," "linked" or "connected" to each other, or another component may be "interposed" between the components".

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

A battery management system (BMS) within a battery pack may be connected to a cell or a cell bank which consists of multiple cells through cell sensing lines (CSLs). When the connectors of these sensing lines are incompletely connected to the cells or the battery management system due to factors such as vibration, collision, or the like in the operating environment, the cell voltage measured by the battery management system may be abnormally measured. In such cases, the battery management system may determine that the cell has a cell over voltage failure (COVF), a cell imbalance failure (CIBF), or the like based on the abnormally measured cell voltage. In response, the battery management system may activate a permanent failure protection function to prevent an accident from occurring due to a bad cell. As such, there is a problem that, despite the cell being in normal condition, the activation of the permanent failure protection function due to a connection defect in the sensing line renders the battery pack permanently unusable.

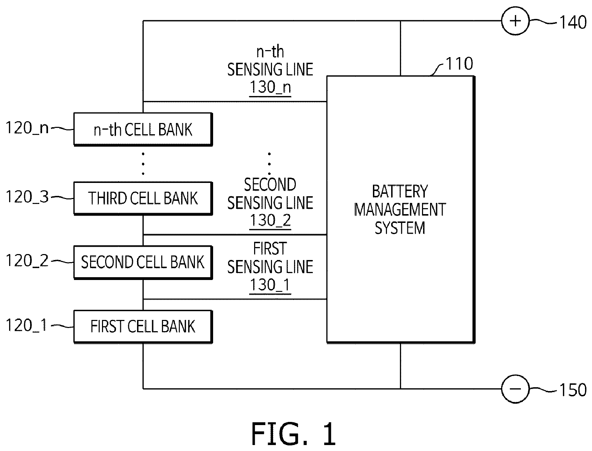

FIG. 1 illustrates an example of a configuration of a battery pack for detecting connection defects in sensing lines according to one embodiment of the present disclosure. **In** one embodiment, at least one processor (e.g., a processor of a battery management system 110) may measure an overall voltage of the battery pack and a voltage of each of a plurality of cell banks 120_1 to 120_n included in the battery pack. Specifically, the processor may measure the voltage of each of the plurality of cell banks 120_1 to 120_n through a plurality of sensing lines 130_1 to 130_n connecting the plurality of cell banks 120_1 to 120_n with the battery management system 110. Here, the plurality of cell banks 120_1 to 120_n connected in series in a direction from a negative electrode 150 to a positive electrode 140 may correspond to the plurality of sensing lines 130_1 to 130_n, respectively. Further, the processor may be connected to each of the positive electrode 140 and the negative electrode 150, for example, as a part of the battery management system 110, to measure the overall voltage of the battery pack.

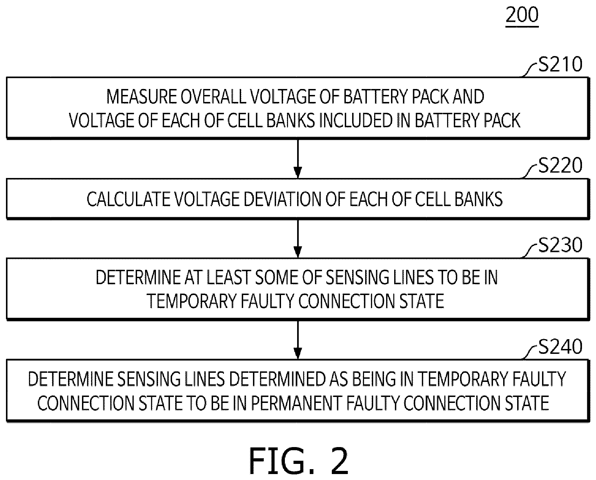

**In** one embodiment, the processor may calculate a voltage deviation of each of the plurality of cell banks 120_1 to 120_n based on the overall voltage and the voltage of each of the plurality of cell banks 120_1 to 120_n. Here, the voltage deviation may represent a difference between the voltage of a particular cell bank and the average voltage of each of the cell banks relative to the overall voltage. An example of calculating the voltage deviation will be described in detail with reference to FIG. 2.

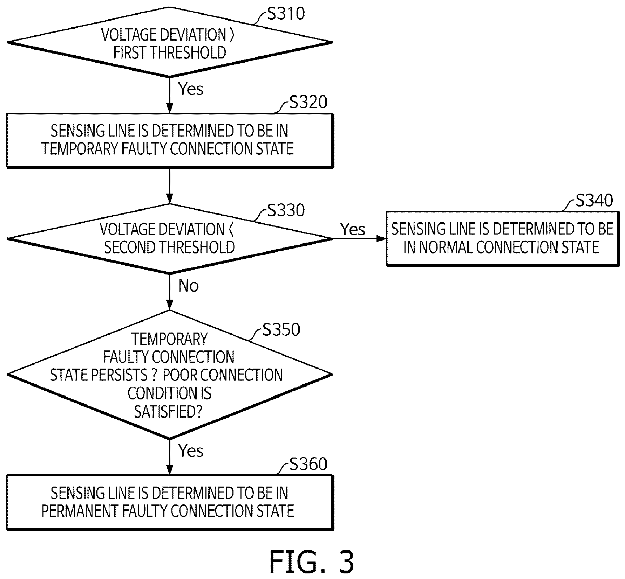

In one embodiment, the processor may determine at least one connection defects of the plurality of sensing lines 130_1 to 130_n associated with the plurality of cell banks 120_1 to 120_n based on the voltage deviation of each of the plurality of cell banks 120_1 to 120_n. Specifically, based on the voltage deviation of each of the plurality of cell banks 120_1 to 120_n, the processor may determine that at least one of the plurality of sensing lines 130_1 to 130_n are in a temporary faulty connection state. For example, if the voltage deviation of each of the first cell bank 120_1 and the second cell bank 120_2 is equal to or greater than a threshold, the processor may determine that the first sensing line 130_1 associated with the first cell bank 120_1 positioned in the direction toward the negative electrode 150 is in a temporary faulty connection state. Further, based on a voltage deviation of the cell bank associated with the sensing line determined as being in the temporary faulty connection state, a predetermined time, and/or a poor connection condition, the processor may further determine the sensing line determined as being in the temporary faulty connection state to be in a permanent faulty connection state. An example of determining the connection state of a sensing line will be described in detail with reference to FIG. 3.

In one embodiment, the processor may activate a temporary failure protection function for a sensing line that is determined as being in a temporary faulty connection state. Here, the temporary failure protection function may refer to a suspending and protecting function that the battery pack is to be in a self-recoverable state where the battery pack can be self-recovered when a temporary faulty connection of the sensing line is restored. Further, the processor may activate a permanent failure protection function for a sensing line that is determined as being in a permanent faulty connection state. Here, the permanent failure protection function may refer to a protecting function that the battery pack is to be in a non-recoverable state where the battery pack cannot be self-recovered to prevent an accidental failure of the battery pack.

With this configuration, the battery management system may first confirm the connection of sensing lines and activate the temporary failure protection function before determining a cell over voltage failure (COVF), a cell imbalance failure (CIBF) or the like, thereby preventing the permanent failure protection function from being activated due to the connection defects in the sensing lines despite the cells being normal (healthy). Consequently, unnecessary disposal of battery packs containing healthy cells can be prevented, reducing disposal costs and improving the availability of battery packs.

FIG. 2 is a diagram illustrating an example of a method 200 for calculating a voltage deviation according to one embodiment of the present disclosure. In one embodiment, the method 200 may be performed by at least one processor (e.g., a processor of a battery management system). The method 200 may begin with the processor measuring an overall voltage of the battery pack and a voltage of each of the plurality of cell banks included in the battery pack (step S210). The processor may then calculate a voltage deviation of each of the plurality of cell banks based on the overall voltage and the voltage of each of the plurality of cell banks (step S220). An example of calculating the voltage deviation of each of the plurality of cell banks may be expressed by the following equation: <Equation 1> ${D}_{i} = Cell {V}_{i} - \frac{Pack V}{N}$ where Dᵢ indicates a voltage deviation of an i-th cell bank, Cell Vᵢ indicates a voltage of the i-th cell bank, Pack V indicates an overall voltage of the battery pack, and N indicates the number of cell banks.

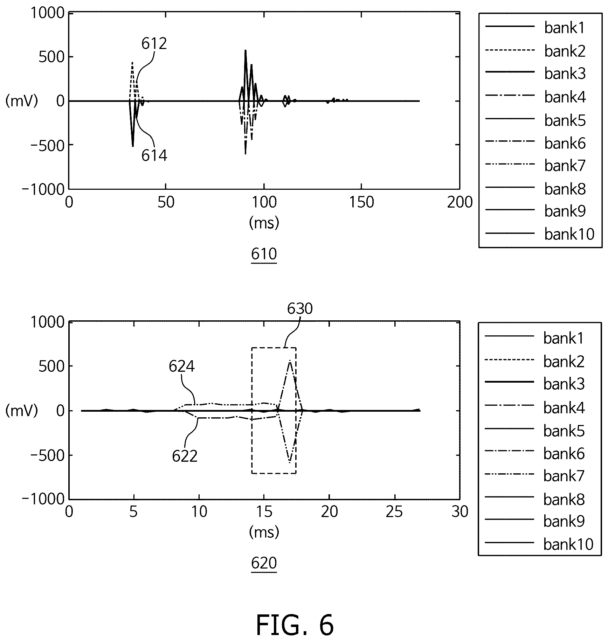

Thereafter, based on the voltage deviation, the processor may determine that at least one of the plurality of sensing lines are in a temporary faulty connection state (step S230). Specifically, the processor may determine a plurality of cell banks associated with connection defects based on the voltage deviation and a predetermined first range. Further, the processor may determine that sensing lines connected between the determined cell banks are in the temporary faulty connection state. For example, referring to FIG. 1, if the voltage deviation of each of the first cell bank 120_1 and the second cell bank 120_2 is outside a first range, the processor may determine that the first sensing line 130_1 associated with the first cell bank 120_1 positioned in the direction toward the negative electrode 150 is in the temporary faulty connection state. Alternatively, the processor may determine that at least one of the plurality of sensing lines are in the temporary faulty connection state using a voltage deviation gradient (ΔD) that is calculated based on the voltage deviation. An example of determining the state of a sensing line based on the voltage deviation gradient will be described in detail with reference to FIG. 6.

Thereafter, based on the voltage deviations of the cell banks associated with the sensing lines determined as being in the temporary faulty connection state, a predetermined time, and/or a poor connection condition, the processor may determine the sensing lines determined as being in the temporary faulty connection state to be in the permanent faulty connection state (step S240). In this case, the processor may provide data regarding the sensing lines determined to have the connection defects and the cell banks associated with those sensing lines to an administrator of the battery pack, for example. Here, the cell banks associated with those sensing lines may correspond to the cell banks positioned in the direction toward the negative electrode between the cell banks associated with the sensing lines determined to have the connection defects.

FIG. 3 is a diagram illustrating an example of a method for determining a connection state of a sensing line in accordance with one embodiment of the present disclosure. In one embodiment, the method for determining the connection state of the sensing line may begin with at least one processor (e.g., a processor of a battery management system) determining whether a voltage deviation(s) (or, an absolute value of the voltage deviation) of a particular cell bank(s) exceeds a predetermined first threshold (step S310). If the voltage deviation exceeds the first threshold, the processor may determine a plurality of cell banks (e.g., two consecutive cell banks) associated with connection defects. Further, the processor may determine that a sensing line(s) connected between the determined cell banks is in the temporary faulty connection state (step S320). In this case, the processor may activate the temporary failure protection function for the sensing line(s) determined as being in the temporary faulty connection state.

Thereafter, the processor may determine whether the voltage deviation(s) of the corresponding cell bank(s) is less than a predetermined second threshold (step S330). If the voltage deviation of the corresponding cell bank becomes less than the second threshold after a predetermined first time period, the processor may determine that the corresponding sensing line has been temporarily disconnected and reconnected. Accordingly, the processor may determine the connection state of the corresponding sensing line as normal (step S340). At this time, the processor may discontinue the protection function (e.g., the temporary failure protection function) of the sensing line determined to have normal connection state.

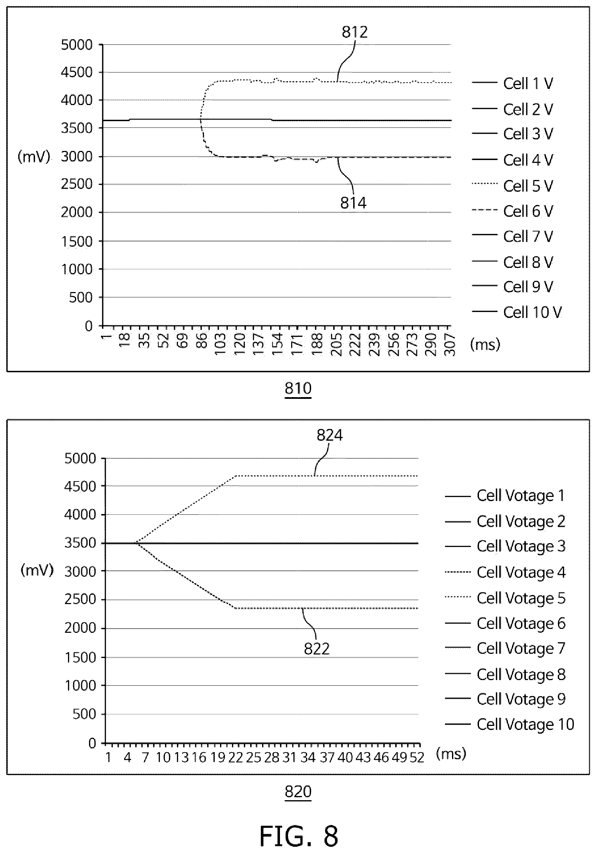

If the voltage deviation(s) of the corresponding cell bank(s) exceeds the second threshold, the processor may determine whether the temporary faulty connection state of the corresponding sensing line(s) persists and whether the voltage deviation satisfies the poor connection condition (step S350). For example, the processor may determine whether the temporary faulty connection state of the corresponding sensing line persists for more than a predetermined second time period. In other words, the processor may determine whether the voltage deviation of the corresponding cell bank is greater than the second threshold for the predetermined second time period. The poor connection condition will be described in detail with reference to FIG. 8.

If the temporary faulty connection state of the sensing line(s) persists for more than the predetermined second time period and the poor connection condition is satisfied, the processor may change the connection state of the sensing line(s) to the permanent faulty connection state (step S360). In this case, the processor may activate the permanent failure protection function for the sensing line determined as being in the permanent faulty connection state. Further, the processor may provide data regarding the sensing line determined to have a connection defect and the cell bank associated with the corresponding sensing line to the administrator of the battery pack, for example.

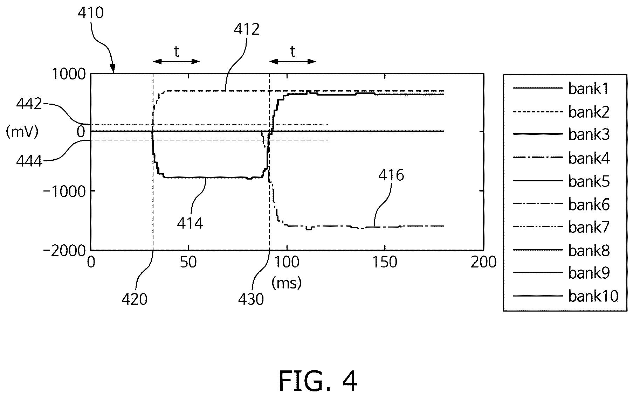

FIG. 4 is a diagram illustrating an example of a voltage deviation graph 410 for a simulation in which there are sensing line connection defects according to one embodiment of the present disclosure. Referring to FIG. 4, the voltage deviation graph 410 is a graph representing voltage deviations occurring when at least one sensing line is experiencing a connection defect, for example, in a case of simulating the operation of the plurality of cell banks and the battery management system having the configurations shown in FIG. 1. Here, the horizontal axis of the voltage deviation graph 410 may represent time and the vertical axis may represent voltage deviation.

In one embodiment, at least one processor may determine a plurality of cell banks associated with the connection defects based on a voltage deviation and a normal range (ranging between a first threshold 442 and a second threshold 444). Here, the absolute values of the first threshold 442 and the second threshold 444 may be the same. Further, the processor may determine that one or more sensing lines connected between the determined cell banks are in the temporary faulty connection state. In this case, the processor may activate the temporary failure protection function for the sensing lines determined as being in the temporary faulty connection state.

For example, at a first time point 420, if a voltage deviation of a bank2 412 exceeds the first threshold 442 and a voltage deviation of a bank3 414 is less than the second threshold 444, the processor may determine that a sensing line connected between the bank2 412 and the bank3 414 is in the temporary faulty connection state. Further, at a second time point 430, if a voltage deviation of a bank3 414 exceeds the first threshold 442 and a voltage deviation of a bank4 416 is less than the second threshold 444, the processor may determine that a sensing line connected between the bank3 414 and the bank4 416 is in the temporary faulty connection state. Accordingly, the temporary failure protection function may be activated for the sensing lines respectively corresponding to the bank2 412 and the bank3 414.

In one embodiment, the processor may determine the sensing lines determined as being in the temporary faulty connection state to be in the permanent faulty connection state based on voltage deviations of the cell banks associated with the sensing lines determined as being in the temporary faulty connection state, a predetermined time, and/or a poor connection condition. In this case, the processor can protect the battery pack by activating the permanent failure protection function for the sensing lines determined as being in the permanent faulty connection state. For example, if the voltage deviations of the bank2 412 and the bank3 414 satisfies the imperfect connection condition and the temporary faulty connection state persists for a predetermined time period t from the first time point 420, the processor may determine the sensing line corresponding to the bank2 412 to be in the permanent faulty connection state. Further, if the voltage deviations of the bank3 414 and the bank4 416 satisfies the poor connection condition and the temporary faulty connection state persists for a predetermined time period t from the second time point 430, the processor may determine the sensing line corresponding to the bank3 414 to be in the permanent faulty connection state. Accordingly, the permanent failure protection function may be activated for the sensing lines respectively corresponding to the bank2 412 and the bank3 414.

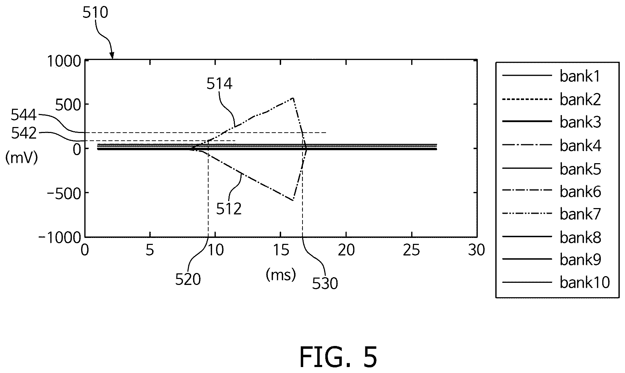

FIG. 5 is a diagram illustrating an example of a voltage deviation graph 510 for a simulation of recovery of the sensing line connection defects according to one embodiment of the present disclosure. In one embodiment, the voltage deviation graph 510 is a graph representing voltage deviations occurring when the temporary faulty connection state of at least one sensing line is recovered, for example, in the case of simulating the operation of the plurality of cell banks and the battery management system having the configurations shown in FIG. 1. Here, the horizontal axis of the voltage deviation graph 510 may represent time and the vertical axis may represent voltage deviation.

In one embodiment, the processor may determine a plurality of cell banks associated with the connection defects based on a voltage deviation and a first threshold 542. Further, the processor may determine that one or more sensing line connected between the determined cell banks are in the temporary faulty connection state. In this case, the processor may activate the temporary failure protection function for the sensing lines determined as being in the temporary faulty connection state.

For example, at a first time point 520, if a voltage deviation of a bank7 514 exceeds the first threshold 542, the processor may determine the bank7 514 to be a cell bank associated with a connection defect. Similarly, the processor may determine a bank6 512 to be also a cell bank associated with a connection defect. In this case, the processor may determine that the sensing line connected between the bank6 512 and the bank7 514 is in the temporary faulty connection state. Accordingly, the processor may activate the temporary failure protection function for the corresponding sensing line.

In one embodiment, the temporary connection defect in the sensing line due to an external impact or the like may be self-recovered. In this case, the processor may determine the sensing line determined as being in the temporary faulty connection state to be in the normal connection state based on a second threshold and the voltage deviations of the cell banks associated with the sensing line determined as being in the temporary faulty connection state. Further, the processor may discontinue the temporary failure protection function of the sensing line determined as being in the normal connection state.

For example, after a predetermined time period after activating the temporary failure protection function for the aforementioned sensing line, the voltage deviation of the bank7 514 may be less than the second threshold 544, for example, at a second time point 530. At this time, the processor may determine that the voltage deviation of the bank7 514 has recovered to normal. Similarly, the processor may determine that the voltage deviation of the bank6 512 has also recovered to normal. In this case, the processor may determine that the sensing line previously determined as being in the temporary faulty connection state to be in the normal connection state, and may discontinue the ongoing temporary failure protection function.

In FIG. 5, it is illustrated that the second threshold 544 is higher than the first threshold 542, but the scope of the present disclosure is not limited thereto. The first threshold 542 and the second threshold 544 can be varied based on hysteresis, hardware characteristics, and/or other factors.

With such a configuration, by confirming the recovery of sensing lines temporarily experiencing connection defects, the temporary failure protection function may be discontinued. Consequently, this prevents the permanent failure protection function from being activated even when the connection state of the sensing lines is temporarily imperfect.

FIG. 6 is a diagram illustrating an example of a method for determining a faulty connection state of a sensing line based on an amount of change in voltage deviation and a pattern of the change according to one embodiment of the present disclosure. A first example 610 shows a graph depicting a simulation result of the amount of change in voltage deviation in a case where the sensing line is experiencing a connection defect as shown in FIG. 4. In addition, a second example 620 shows a graph depicting a simulation result of the amount of change in voltage deviation in a case where the sensing line having the connection defect is recovered as shown in FIG. 5.

In one embodiment, the processor may determine that at least some of the plurality of sensing lines are in the temporary faulty connection state based on the amount of change in voltage deviation. For example, the processor may calculate, based on the voltage deviation, an amount of change in voltage deviation per unit time for each of the plurality of cell banks. Further, the processor may determine, based on the amount of change in voltage deviation and the pattern of the change, a plurality of cell banks associated with the connection defects. Further, the processor may determine that a sensing line(s) connected between the determined cell banks is in the temporary faulty connection state. The amount of change in voltage deviation per unit time may be expressed by the following equation: <Equation 2> $Δ {D}_{i} = {D}_{i} \left(t\right) - {D}_{i} \left(t-1\right)$ where t indicates unit time.

**In** one embodiment, referring to the first example 610, if the amount of change in voltage deviation of each of a bank2 612 and a bank3 614 falls outside a predetermined normal range, the processor may determine that a sensing line connected between the bank2 612 and the bank3 614 is experiencing the connection defect. **In** this case, the processor may determine that the corresponding sensing line is in the temporary faulty connection state. Subsequently, based on the amount of change in voltage deviation of each of the bank2 612 and the bank3 614 converging back to 0, indicating that the temporary faulty connection state persists for a predetermined time period, the processor may determine the sensing line previously determined as being in the temporary faulty connection state to be in the permanent faulty connection state.

In one embodiment, referring to the second example 620, if the amount of change in the voltage deviation of each of a bank6 622 and a bank7 624 is outside of the normal range, the processor may determine that a sensing line connected between the bank6 622 and the bank7 624 is experiencing the connection defect. In this case, the processor may determine that the corresponding sensing line is in the temporary faulty connection state. Subsequently, based on the reversal of the amount of change in voltage deviation of each of the bank6 622 and the bank7 624 in an intersection region 630, the processor may determine that the temporary faulty connection state of the corresponding sensing line has been recovered. Accordingly, the processor may determine the corresponding sensing line to be in the normal connection state.

With such a configuration, the amount of change in voltage deviation can be used to determine the sensing line connection defects. In addition, by using voltage deviation together with the amount of change in voltage deviation, it is possible to more accurately assess the connection defects of the sensing lines.

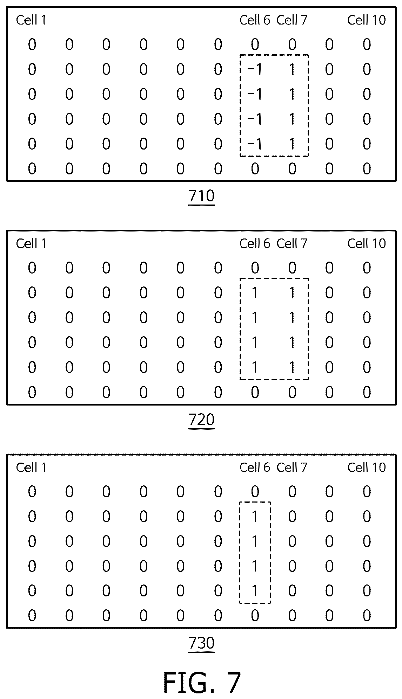

FIG. 7 is a diagram illustrating an example of a method for detecting connection defects in sensing lines based on a display of voltage deviations of cell banks according to one embodiment of the present disclosure. In one embodiment, based on the voltage of each of the plurality of cell banks and the overall voltage of the battery pack, a voltage deviation of each of the plurality of cell banks may be calculated. Data associated with these voltage deviations may be briefly output on a display (e.g., a display of a terminal associated with the administrator of the battery pack). For example, if the voltage deviation falls within a predetermined normal range, the output data may be displayed as zero. If the voltage deviation is not within the predetermined normal range, the output data may be displayed as either 1 or -1 depending on the sign of the voltage deviation. Here, the output data for each cell may be displayed over unit time intervals. Referring to a first operation 710, as the voltage deviations of a sixth cell bank (Cell 6) and a seventh cell bank (Cell 7) are not within the normal range, the output data of the sixth cell bank (Cell 6) and the seventh cell bank (Cell 7) may be displayed as -1 and 1, respectively.

In one embodiment, the plurality of cells that have the voltage deviations outside the normal range may be determined to be cell banks associated with the connection defects. Accordingly, the sensing lines connected between the corresponding cells may be determined to be in the temporary faulty connectivity state. Referring to a second operation 720, as the sixth cell bank (Cell 6) and the seventh cell bank (Cell 7) are determined to be the cell banks associated with the connection defects, output data for the sixth cell bank (Cell 6) and the seventh cell bank (Cell 7) may be displayed accordingly. In this case, the output data of "-1" for the 6th cell bank (Cell 6) may be converted and displayed as "1."

In one embodiment, based on a voltage deviation of a cell bank associated with a sensing line determined as being in the temporary faulty connection state, a predetermined time, and a poor connection condition, the sensing line determined as being in the temporary faulty connection state may be further designated to be in the permanent faulty connection state. Referring to a third operation 730, the plurality of cell banks respectively correspond to a plurality of sensing lines and the cell bank associated with the sensing line determined as being in the temporary faulty connection state corresponds to the cell bank positioned in the direction toward the negative electrode, the output data for only the sixth cell bank (Cell 6) may be separately displayed. Accordingly, if the output data for the sixth cell bank (Cell 6) outputs "1" for a predetermined time period while satisfying the poor connection condition, a sensing line (or, a sixth sensing line) corresponding to the sixth cell bank (Cell 6) may be determined to be in the permanent faulty connection state.

FIG. 8 is a diagram illustrating an example of a poor connection condition according to one embodiment of the present disclosure. A first graph 810 represents an example of a first condition associated with a poor connection of a sensing line. Further, the second graph 820 represents an example of a second condition associated with the poor connection of the sensing line.

In one embodiment, when a particular sensing line is experiencing a connection defect, the voltage of a first cell bank associated with the corresponding sensing line and positioned in the direction toward the negative electrode with respect to the corresponding sensing line may be distributed by a resistor, a capacitor, a Zener diode, an input impedance, and/or the like. Accordingly, the voltage of the first cell bank associated with the corresponding sensing line and positioned in the direction toward the negative electrode with respect to the corresponding sensing line and the voltage of a second cell bank connected in series with the first cell bank in the direction toward the positive electrode may be increased or decreased with different polarities.

In one embodiment, if the voltage deviations of two consecutive cell banks fall outside a predetermined normal range due to a connection defect in a sensing line, the voltage deviation of a first cell bank corresponding to the sensing line experiencing the connection defect (i.e., the cell bank associated with the sensing line experiencing the connection defect and positioned in the direction toward the negative electrode with respect to the sensing line experiencing the connection defect) may be increased as a first condition. In this case, the voltage deviation of a second cell bank connected to the first cell bank in the direction toward the positive electrode may be decreased. For example, if a fifth sensing line is experiencing the connection defect, the voltage deviation of a fifth cell bank 812 may be increased and the voltage deviation of a sixth cell bank 814 connected to the fifth cell bank 812 in the direction toward the positive electrode may be decreased.

In one embodiment, if the voltage deviation of two consecutive cell banks falls outside a predetermined normal range due to a connection defect in a sensing line, the voltage deviation of a first cell bank corresponding to the sensing line experiencing the connection defect may be decreased as a second condition. In this case, the voltage deviation of a second cell bank connected to the first cell bank in the direction toward the positive electrode may be increased. For example, if a fourth sensing line is experiencing the connection defect, the voltage deviation of a fourth cell bank 822 may be decreased, and the voltage deviation of a fifth cell bank 824 connected to the fourth cell bank 822 in the direction toward the positive electrode may be decreased.

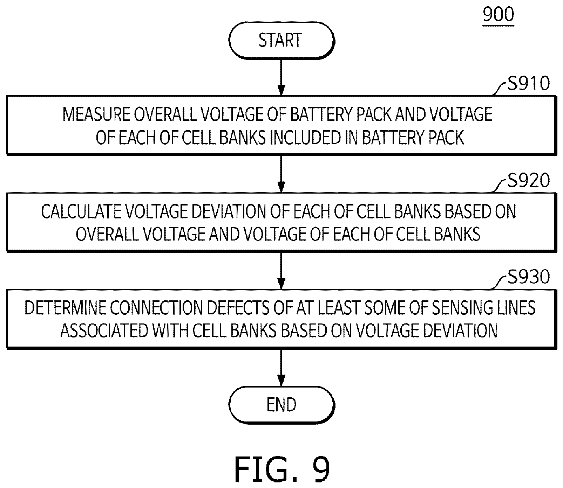

FIG. 9 is a flowchart illustrating an example of a method 900 for detecting sensing line connection defects according to one embodiment of the present disclosure. In one embodiment, the method 900 may be performed by at least one processor (e.g., at least one processor of a battery management system). The method 900 may begin with the processor measuring an overall voltage of a battery pack and a voltage of each of a plurality of cell banks included in the battery pack (step S910). Further, the processor may calculate a voltage deviation of each of the plurality of cell banks based on the overall voltage and the voltage of each of the plurality of cell banks (step S920).

Subsequently, the processor may determine connection defects of at least some of the plurality of sensing lines associated with the plurality of cell banks based on the voltage deviation (step S930). Specifically, based on the voltage deviation, the processor may determine that at least some of the plurality of sensing lines are in the temporary faulty connection state. In this case, the processor may activate the temporary failure protection function for the sensing lines determined as being in the temporary faulty connection state.

In one embodiment, the processor may determine the sensing lines determined as being in the temporary faulty connection state to be in the permanent faulty connection state based on voltage deviations of the plurality of cell banks associated with the sensing lines determined as being in the temporary faulty connection state, a predetermined time, and a poor connection condition. Here, the poor connection condition may include a first condition in which a voltage deviation of a first cell bank associated with the sensing line determined as being in the temporary faulty connection state is increased and a voltage deviation of a second cell bank connected in series with the first cell bank in a positive electrode direction from the first cell bank is decreased, or a second condition in which the voltage deviation of the first cell bank is decreased and the voltage deviation of the second cell bank is increased. In this case, the processor may activate the permanent failure protection function for the sensing lines determined as being in the permanent faulty connection state.

In one embodiment, the processor may determine a plurality of cell banks associated with the connection defects based on the voltage deviation and a predetermined first range. Further, the processor may determine one or more sensing lines connected between the determined cell banks to be in a temporary faulty connection state.

In one embodiment, the processor may calculate, based on the voltage deviation, an amount of change in voltage deviation per unit time for each of a plurality of cell banks. Further, the processor may determine a plurality of cell banks associated with the connection defects based on the amount of change in voltage deviation and a pattern of the change. Further, the processor may determine connection defects of one or more sensing lines connected between the determined cell banks.

In one embodiment, the processor may separately monitor voltage deviations of the plurality of cell banks associated with one or more sensing lines determined as being in the temporary faulty connection state. Further, based on a predetermined second range and the voltage deviations of the plurality of cell banks associated with the one or more sensing lines determined as being in the temporary faulty connection state, the processor may determine the one or more sensing line determined as being in the temporary faulty connection state to be in a normal connection state. Additionally, the processor may discontinue the protection function of the one or more sensing lines determined as being in the normal connection state.

In one embodiment, the processor may provide data regarding the sensing line determined to have the connection defect and a cell bank associated with the sensing line. Here, the cell bank associated with the sensing line may correspond to a cell bank positioned in a direction toward a negative electrode between the plurality of cell banks associated with the sensing line determined to have the connection defect.

The methods described above may be configured in a form of computer programs stored in non-transitory computer-readable media to be executed through various computer devices. Here, the media may continuously store computer-executable programs or may transitorily store the same for execution or download. Also, the media may be various types of recording devices or storage devices in a form in which one or a plurality of hardware components are combined. Without being limited to media directly connected to a computer system, the media may be distributed over the network. Examples of the media include magnetic media such as hard disks, floppy disks, and magnetic media such as magnetic tapes; optical media such as CD-ROM and DVDs; magneto-optical media such as floptical disks; and hardware devices that are specially configured to store program instructions, such as read-only memory (ROM), random access memory (RAM), flash memory, and the like. Examples of other media may include record media and storage media managed by Appstore that distributes applications or a site that supplies and distributes other various types of software, a server, and the like.

The methods, operations, or techniques of the present disclosure may be implemented by various means. For example, these techniques may be implemented in hardware, firmware, software, or a combination thereof. Those skilled in the art will further appreciate that various illustrative logical blocks, modules, circuits, and algorithm steps described in connection with the disclosure herein may be implemented in electronic hardware, computer software, or combinations of both. To clearly illustrate this interchangeability of hardware and software, various illustrative components, blocks, modules, circuits, and steps have been described above generally in terms of their functionality. Whether such a function is implemented as hardware or software varies depending on design requirements imposed on the particular application and the overall system. Those skilled in the art may implement the described functions in varying ways for each particular application, but such implementation should not be interpreted as causing a departure from the scope of the present disclosure.

In a hardware implementation, processing units used to perform the techniques may be implemented in one or more ASICs, DSPs, GPUs, digital signal processing devices (DSPDs), programmable logic devices (PLDs), field programmable gate arrays (FPGAs), processors, controllers, microcontrollers, microprocessors, electronic devices, other electronic units designed to perform the functions described in the present disclosure, computer, or a combination thereof.

Accordingly, various example logic blocks, modules, and circuits described in connection with the present disclosure may be implemented or performed with general purpose processors, DSPs, ASICs, FPGAs or other programmable logic devices, discrete gate or transistor logic, discrete hardware components, or any combination of those designed to perform the functions described herein. The general purpose processor may be a microprocessor, but in the alternative, the processor may be any related processor, controller, microcontroller, or state machine. The processor may also be implemented as a combination of computing devices, for example, a DSP and microprocessor, a plurality of microprocessors, one or more microprocessors associated with a DSP core, or any other combination of the configurations.

In the implementation using firmware and/or software, the techniques may be implemented with instructions stored on a computer-readable medium, such as random access memory (RAM), read-only memory (ROM), non-volatile random access memory (NVRAM), programmable read-only memory (PROM), erasable programmable read-only memory (EPROM), electrically erasable PROM (EEPROM), flash memory, compact disc (CD), magnetic or optical data storage devices, and the like. The instructions may be executable by one or more processors, and may cause the processor(s) to perform certain aspects of the functions described in the present disclosure.

When implemented in software, the techniques may be stored on a computer-readable medium as one or more instructions or codes, or may be transmitted through a computer-readable medium. The computer-readable media include both the computer storage media and the communication media including any medium that facilitates the transfer of a computer program from one place to another. The storage media may also be any available media that may be accessed by a computer. By way of non-limiting example, such a computer-readable medium may include RAM, ROM, EEPROM, CD-ROM or other optical disk storage, magnetic disk storage or other magnetic storage devices, or any other media that can be used to transfer or store desired program code in the form of instructions or data structures and can be accessed by a computer. In addition, any connection is properly performed by a computer-readable medium.

For example, when the software is transmitted from a website, server, or other remote sources using coaxial cable, fiber optic cable, twisted pair, digital subscriber line (DSL), or wireless technologies such as infrared, wireless, and microwave, the coaxial cable, the fiber optic cable, the twisted pair, the digital subscriber line, or the wireless technologies such as infrared, wireless, and microwave are included within the definition of the medium. The disks and the discs used herein include CDs, laser disks, optical disks, digital versatile discs (DVDs), floppy disks, and Blu-ray disks, where disks usually magnetically reproduce data, while discs optically reproduce data using a laser. The combinations described above should also be included within the scope of the computer-readable media.

The software module may reside in RAM memory, flash memory, ROM memory, EPROM memory, EEPROM memory, registers, hard disk, removable disk, CD-ROM, or any other form of storage medium known. An exemplary storage medium may be connected to the processor, such that the processor may read or write information from or to the storage medium. Alternatively, the storage medium may be integrated into the processor. The processor and the storage medium may exist in the ASIC. The ASIC may exist in the user terminal. Alternatively, the processor and storage medium may exist as separate components in the user terminal.

Although the examples described above have been described as utilizing aspects of the currently disclosed subject matter in one or more standalone computer systems, the present disclosure is not limited thereto, and may be implemented in conjunction with any computing environment, such as a network or distributed computing environment. Furthermore, the aspects of the subject matter in the present disclosure may be implemented in multiple processing chips or devices, and storage may be similarly influenced across a plurality of devices. Such devices may include PCs, network servers, and portable devices.

## Claims

1. A computer implemented method for detecting a connection defect in a sensing line (130), the method comprising:
receiving a measured overall voltage of a battery pack and a measured voltage of each of a plurality of cell banks (120) included in the battery pack;
calculating (S920), based on the received overall voltage and the received voltage of each of the plurality of cell banks (120), a voltage deviation associated with each of the plurality of cell banks (120); and
determining (S930), based on the calculated voltage deviation, one or more connection defects of at least one of a plurality of sensing lines (130) associated with the plurality of cell banks (120), wherein the determining (S930) of the one or more connection defects comprises:
calculating, based on the calculated voltage deviation, an amount of change in voltage deviation per unit time for each of the plurality of cell banks (120);
determining, based on the calculated amount of change in voltage deviation and a pattern of the change, a plurality of cell banks (120) associated with the one or more connection defects; and
determining whether a sensing line (130) connected between the determined plurality of cell banks (120) has a connection defect.

2. The method as claimed in claim 1, wherein the step of receiving the measured overall voltage of the battery pack and the measured voltage of each of the plurality of cell banks (120) comprises measuring (S910) the overall voltage of the battery pack and the voltage of each of the plurality of cell banks (120) included in the battery pack; and/or wherein the determining (S930) of the one or more connection defects comprises determining (S230), based on the calculated voltage deviation, that the at least one of the plurality of sensing lines (130) is in an at least temporary faulty connection state.

3. The method as claimed in claim 2, wherein the determining (S230) that the at least one of the plurality of sensing lines (130) is in the at least temporary faulty connection state comprises:
determining, based on the calculated voltage deviation and a predetermined first range, a plurality of cell banks (120) associated with the one or more connection defects; and
determining a sensing line (130) connected between the determined cell banks (120) to be in the at least temporary faulty connection state.

4. The method according to any of claims 2 to 3, further comprising:
activating a temporary failure protection function for the at least one of the plurality of sensing lines (130) determined as being in the at least temporary faulty connection state.

5. The method according to any of claims 2 to 4, the determining (S930) of the one or more connection defects further comprises:
separately monitoring the calculated voltage deviations for the plurality of cell banks (120) associated with the at least one of the plurality of sensing lines (130) determined as being in the at least temporary faulty connection state.

6. The method according to any of claims 2 to 5, the determining (S930) of the one or more connection defects further comprises:
determining, based on a predetermined second range and the calculated voltage deviations for a plurality of cell banks (120) associated with the at least one of the plurality of sensing lines (130) determined as being in the at least temporary faulty connection state, that the at least one of the plurality of sensing lines (130) determined as being in the at least temporary faulty connection state is in a normal connection state.

7. The method as claimed in claim 6, further comprising:
interrupting a protection function of the at least one of the plurality of sensing lines (130) determined as being in the normal connection state.

8. The method according to any of claims 2 to 7, wherein the determining (S930) of the one or more connection defects further comprises:
Determining (S240) the at least one of the plurality of sensing lines (130) determined as being in the at least temporary faulty connection state to be in a permanent faulty connection state based on the calculated voltage deviations of a plurality of cell banks (120) associated with the at least one of the plurality of sensing lines (130) determined as being in the at least temporary faulty connection state, a predetermined time, and a poor connection condition.

9. The method as claimed in claim 8, wherein the poor connection condition comprises
a) a first condition in which a voltage deviation of a first cell bank (120) associated with one of the at least one of the plurality of sensing lines (130) determined as being in the at least temporary faulty connection state is increased, and a voltage deviation of a second cell bank (120) connected in series to the first cell bank (120) in a positive electrode direction from the first cell bank (120) is decreased; or
b) a second condition in which a voltage deviation of a first cell bank (120) associated with one of the at least one of the plurality of sensing lines (130) determined as being in the at least temporary faulty connection state is decreased and a voltage deviation of a second cell bank (120) connected in series to the first cell bank (120) in a positive electrode direction from the first cell bank (120) is increased;
and wherein for a) and b) the voltage deviation is increased or decreased in comparison to the voltage deviation of a cell bank (120) not being associated with one of the at least one of the plurality of sensing lines (130) determined as being in the at least temporary faulty connection state.

10. The method according to any of claims 8 or 9, further comprising:
activating a permanent failure protection function for the at least one of the plurality of sensing lines (130) determined as being in the permanent faulty connection state.

11. The method according to any of the previous claims, further comprising:
providing data regarding a sensing line (130) determined to have the one or more connection defects and a cell bank (120) associated with the sensing line (130).

12. The method as claimed in claim 11, wherein the cell bank (120) associated with the sensing line (130) corresponds to a cell bank (120) positioned in a direction toward a negative electrode between a plurality of cell banks (120) associated with the sensing line (130) determined to have the one or more connection defects.

13. At least one non-transitory computer-readable storage medium storing instructions for executing the method as claimed in any of the previous claims on a computer.

14. A battery pack comprising:
a battery management system (BMS) (110);
a plurality of cell banks (120) connected in series; and
a plurality of sensing lines (130) connecting the plurality of cell banks (120) with the battery management system (110),
wherein the battery management system (110) is configured to calculate, based on an overall voltage of the battery pack and a voltage of each of the plurality of cell banks (120), voltage deviations associated with at least one of the plurality of cell banks (120), and
the battery management system (110) is further configured to determine, based on the calculated voltage deviations, one or more connection defects in at least one of the plurality of sensing lines (130) associated with the plurality of cell banks (120), and
wherein the battery management system (110) is further configured such that the determining of the one or more connection defects comprises:
calculating, based on the calculated voltage deviation, an amount of change in voltage deviation per unit time for each of the plurality of cell banks (120);
determining, based on the calculated amount of change in voltage deviation and a pattern of the change, a plurality of cell banks (120) associated with the one or more connection defects; and
determining whether a sensing line (130) connected between the determined plurality of cell banks (120) has a connection defect.

## Patentansprüche

1. Computerimplementiertes Verfahren zum Erkennen eines Verbindungsdefekts in einer Messleitung (130), wobei das Verfahren umfasst:
Empfangen einer gemessenen Gesamtspannung eines Batteriepacks und einer gemessenen Spannung jeder aus einer Mehrzahl von Zellbänken (120), die in dem Batteriepack enthalten sind;
Berechnen (S920), basierend auf der empfangenen Gesamtspannung und der empfangenen Spannung jeder der Mehrzahl von Zellbänken (120), einer Spannungsabweichung, die der jeweiligen der Mehrzahl von Zellbänken (120) zugeordnet ist; und
Bestimmen (S930), basierend auf der berechneten Spannungsabweichung, eines oder mehrerer Verbindungsdefekte mindestens einer aus einer Mehrzahl von Messleitungen (130), die der Mehrzahl von Zellbänken (120) zugeordnet sind, wobei das Bestimmen (S930) der einen oder mehreren Verbindungsdefekte umfasst:
Berechnen, basierend auf der berechneten Spannungsabweichung, eines Änderungsbetrags der Spannungsabweichung pro Zeiteinheit für jede der Mehrzahl von Zellbänken (120);
Bestimmen, basierend auf dem berechneten Änderungsbetrag der Spannungsabweichung und einem Muster der Änderung, einer Mehrzahl von Zellbänken (120), die den einen oder mehreren Verbindungsdefekten zugeordnet sind; und
Bestimmen, ob eine zwischen der bestimmten Mehrzahl von Zellbänken (120) angeschlossene Messleitung (130) einen Verbindungsdefekt aufweist.

2. Verfahren nach Anspruch 1, wobei der Schritt des Empfangens der gemessenen Gesamtspannung des Batteriepacks und der gemessenen Spannung jeder der Mehrzahl von Zellbänken (120) Messen (S910) der Gesamtspannung des Batteriepacks und der Spannung jeder der Mehrzahl von Zellbänken (120), die in dem Batteriepack enthalten sind, umfasst; und/oder wobei das Bestimmen (S930) der einen oder mehreren Verbindungsdefekte Bestimmen (S230), basierend auf der berechneten Spannungsabweichung, umfasst, dass sich die mindestens eine der Mehrzahl von Messleitungen (130) in einem zumindest vorübergehend fehlerhaften Verbindungszustand befindet.

3. Verfahren nach Anspruch 2, wobei das Bestimmen (S230), dass sich die mindestens eine der Mehrzahl von Messleitungen (130) in dem zumindest vorübergehend fehlerhaften Verbindungszustand befindet, umfasst:
Bestimmen, basierend auf der berechneten Spannungsabweichung und einem vorbestimmten ersten Bereich, einer Mehrzahl von Zellbänken (120), die den einen oder mehreren Verbindungsdefekten zugeordnet sind; und
Bestimmen, dass sich eine zwischen den bestimmten Zellbänken (120) angeschlossene Messleitung (130) in dem zumindest vorübergehend fehlerhaften Verbindungszustand befindet.

4. Verfahren nach einem der Ansprüche 2 bis 3, ferner umfassend:
Aktivieren einer Schutzfunktion bei vorübergehendem Fehler für die mindestens eine der Mehrzahl von Messleitungen (130), die als in dem zumindest vorübergehend fehlerhaften Verbindungszustand befindlich bestimmt wurde.

5. Verfahren nach einem der Ansprüche 2 bis 4, wobei das Bestimmen (S930) der einen oder mehreren Verbindungsdefekte ferner umfasst:
separates Überwachen der berechneten Spannungsabweichungen für die Mehrzahl von Zellbänken (120), die der mindestens einen der Mehrzahl von Messleitungen (130) zugeordnet sind, die als in dem zumindest vorübergehend fehlerhaften Verbindungszustand befindlich bestimmt wurde.

6. Verfahren nach einem der Ansprüche 2 bis 5, wobei das Bestimmen (S930) der einen oder mehreren Verbindungsdefekte ferner umfasst:
Bestimmen, basierend auf einem vorbestimmten zweiten Bereich und den berechneten Spannungsabweichungen für eine Mehrzahl von Zellbänken (120), die der mindestens einen der Mehrzahl von Messleitungen (130) zugeordnet sind, die als in dem zumindest vorübergehend fehlerhaften Verbindungszustand befindlich bestimmt wurde, dass sich die mindestens eine der Mehrzahl von Messleitungen (130), die als in dem zumindest vorübergehend fehlerhaften Verbindungszustand befindlich bestimmt wurde, in einem normalen Verbindungszustand befindet.

7. Verfahren nach Anspruch 6, ferner umfassend:
Unterbrechen einer Schutzfunktion der mindestens einen der Mehrzahl von Messleitungen (130), die als in dem normalen Verbindungszustand befindlich bestimmt wurde.

8. Verfahren nach einem der Ansprüche 2 bis 7, wobei das Bestimmen (S930) der einen oder mehreren Verbindungsdefekte ferner umfasst:
Bestimmen (S240), basierend auf den berechneten Spannungsabweichungen einer Mehrzahl von Zellbänken (120), die der mindestens einen der Mehrzahl von Messleitungen (130) zugeordnet sind, die als in dem zumindest vorübergehend fehlerhaften Verbindungszustand befindlich bestimmt wurde, einer vorbestimmten Zeit und einer Bedingung für eine mangelhafte Verbindung, dass sich die mindestens eine der Mehrzahl von Messleitungen (130), die als in dem zumindest vorübergehend fehlerhaften Verbindungszustand befindlich bestimmt wurde, in einem dauerhaft fehlerhaften Verbindungszustand befindet.

9. Verfahren nach Anspruch 8, wobei die Bedingung für eine mangelhafte Verbindung umfasst:
a) eine erste Bedingung, bei der eine Spannungsabweichung einer ersten Zellbank (120), die einer der mindestens einen der Mehrzahl von Messleitungen (130) zugeordnet ist, die als in dem zumindest vorübergehend fehlerhaften Verbindungszustand befindlich bestimmt wurde, erhöht ist und eine Spannungsabweichung einer zweiten Zellbank (120), die in Richtung der positiven Elektrode von der ersten Zellbank (120) aus mit der ersten Zellbank (120) in Reihe geschaltet ist, verringert ist; oder
b) eine zweite Bedingung, bei der eine Spannungsabweichung einer ersten Zellbank (120), die einer der mindestens einen der Mehrzahl von Messleitungen (130) zugeordnet ist, die als in dem zumindest vorübergehend fehlerhaften Verbindungszustand befindlich bestimmt wurde, verringert ist und eine Spannungsabweichung einer zweiten Zellbank (120), die in Richtung der positiven Elektrode von der ersten Zellbank (120) aus mit der ersten Zellbank (120) in Reihe geschaltet ist, erhöht ist;
und wobei für a) und b) die Spannungsabweichung verglichen mit der Spannungsabweichung einer Zellbank (120), die keiner der mindestens einen der Mehrzahl von Messleitungen (130) zugeordnet ist, die als in dem zumindest vorübergehend fehlerhaften Verbindungszustand befindlich bestimmt wurde, erhöht oder verringert ist.

10. Verfahren nach einem der Ansprüche 8 oder 9, ferner umfassend:
Aktivieren einer Schutzfunktion bei dauerhaftem Fehler für die mindestens eine der Mehrzahl von Messleitungen (130), die als in dem dauerhaft fehlerhaften Verbindungszustand befindlich bestimmt wurde.

11. Verfahren nach einem der vorhergehenden Ansprüche, ferner umfassend:
Bereitstellen von Daten bezüglich einer Messleitung (130), für die bestimmt wurde, dass sie die einen oder mehreren Verbindungsdefekte aufweist, und einer Zellbank (120), die der Messleitung (130) zugeordnet ist.

12. Verfahren nach Anspruch 11, wobei die der Messleitung (130) zugeordnete Zellbank (120) einer Zellbank (120) entspricht, die unter einer Mehrzahl von Zellbänken (120), die der Messleitung (130) zugeordnet sind, für die bestimmt wurde, dass sie die einen oder mehreren Verbindungsdefekte aufweist, in einer Richtung hin zu einer negativen Elektrode positioniert ist.

13. Mindestens ein nichtflüchtiges computerlesbares Speichermedium, auf dem Anweisungen zum Ausführen des Verfahrens nach einem der vorhergehenden Ansprüche auf einem Computer gespeichert sind.

14. Batteriepack, aufweisend:
ein Batteriemanagementsystem (BMS) (110);
eine Mehrzahl von in Reihe geschalteten Zellbänken (120); und
eine Mehrzahl von Messleitungen (130), die die Mehrzahl von Zellbänken (120) mit dem Batteriemanagementsystem (110) verbinden,
wobei das Batteriemanagementsystem (110) dazu eingerichtet ist, basierend auf einer Gesamtspannung des Batteriepacks und einer Spannung jeder der Mehrzahl von Zellbänken (120) Spannungsabweichungen zu berechnen, die mindestens einer der Mehrzahl von Zellbänken (120) zugeordnet sind, und
das Batteriemanagementsystem (110) ferner dazu eingerichtet ist, basierend auf den berechneten Spannungsabweichungen einen oder mehrere Verbindungsdefekte in mindestens einer der Mehrzahl von Messleitungen (130), die der Mehrzahl von Zellbänken (120) zugeordnet sind, zu bestimmen, und
wobei das Batteriemanagementsystem (110) ferner derart eingerichtet ist, dass das Bestimmen der einen oder mehreren Verbindungsdefekte umfasst:
Berechnen, basierend auf der berechneten Spannungsabweichung, eines Änderungsbetrags der Spannungsabweichung pro Zeiteinheit für jede der Mehrzahl von Zellbänken (120);
Bestimmen, basierend auf dem berechneten Änderungsbetrag der Spannungsabweichung und einem Muster der Änderung, einer Mehrzahl von Zellbänken (120), die den einen oder mehreren Verbindungsdefekten zugeordnet sind; und
Bestimmen, ob eine zwischen der bestimmten Mehrzahl von Zellbänken (120) angeschlossene Messleitung (130) einen Verbindungsdefekt aufweist.

## Revendications

1. Procédé mis en œuvre par ordinateur pour détecter un défaut de connexion dans une ligne de détection (130), le procédé comprenant:
la réception d'une tension globale mesurée d'un bloc-batterie et d'une tension mesurée de chacun d'une pluralité de bancs de cellules (120) inclus dans le bloc-batterie;
le calcul (S920), sur la base de la tension globale reçue et de la tension reçue de chacun de la pluralité de bancs de cellules (120), d'un écart de tension associé à chacun de la pluralité de bancs de cellules (120); et
la détermination (S930), sur la base de l'écart de tension calculé, d'un ou de plusieurs défauts de connexion d'au moins une d'une pluralité de lignes de détection (130) associée à la pluralité de bancs de cellules (120), dans lequel la détermination (S930) du ou des défauts de connexion comprend:
le calcul, sur la base de l'écart de tension calculé, d'une quantité de changement d'écart de tension par unité de temps pour chacun de la pluralité de bancs de cellules (120);
la détermination, sur la base de la quantité calculée de changement dans la déviation de tension et d'un motif de changement, d'une pluralité de bancs de cellules (120) associés au ou aux défauts de connexion; et
la détermination si une ligne de détection (130) connectée entre la pluralité déterminée de bancs de cellules (120) présente un défaut de connexion.

2. Procédé selon la revendication 1, dans lequel l'étape de réception de la tension globale mesurée du bloc-batterie et de la tension mesurée de chacun de la pluralité de bancs de cellules (120) comprend la mesure (S910) de la tension globale du bloc-batterie et de la tension de chacun de la pluralité de bancs de cellules (120) inclus dans le bloc-batterie; et/ou dans lequel la détermination (S930) du ou des défauts de connexion comprend la détermination (S230), sur la base de l'écart de tension calculé, qu'au moins une de la pluralité de lignes de détection (130) se trouve dans un état de connexion au moins temporairement défaillante.

3. Procédé selon la revendication 2, dans lequel la détermination (S230) que ladite au moins une de la pluralité de lignes de détection (130) se trouve dans l'état de connexion au moins temporairement défaillante comprend:
la détermination, sur la base de l'écart de tension calculé et d'une première plage prédéterminée, d'une pluralité de bancs de cellules (120) associés au ou aux défauts de connexion; et
la détermination qu'une ligne de détection (130) connectée entre les bancs de cellules (120) déterminés se trouve dans l'état de connexion au moins temporairement défaillante.

4. Procédé selon l'une quelconque des revendications 2 à 3, comprenant en outre:
l'activation d'une fonction de protection contre les défaillances temporaires pour ladite au moins une de la pluralité de lignes de détection (130) identifiée comme étant dans l'état de connexion au moins temporairement défaillante.

5. Procédé selon l'une quelconque des revendications 2 à 4, la détermination (S930) du ou des défauts de connexion comprend en outre:
la surveillance séparée des écarts de tension calculés pour la pluralité de bancs de cellules (120) associés à ladite au moins une ligne de détection (130) identifiée comme étant dans l'état de connexion au moins temporairement défaillante.

6. Procédé selon l'une quelconque des revendications 2 à 5, la détermination (S930) du ou des défauts de connexion comprend en outre:
la détermination, sur la base d'une deuxième plage prédéterminée et des écarts de tension calculés pour une pluralité de bancs de cellules (120) associés à ladite au moins une de la pluralité de lignes de détection (130) identifiée comme étant dans l'état de connexion au moins temporairement défaillante, que ladite au moins une de la pluralité de lignes de détection (130) identifiée comme étant dans l'état de connexion au moins temporairement défaillante, se trouve dans un état de connexion normale.

7. Procédé selon la revendication 6, comprenant en outre:
l'interruption d'une fonction de protection de ladite au moins une de la pluralité de lignes de détection (130) identifiée comme étant dans l'état de connexion normale.

8. Procédé selon l'une quelconque des revendications 2 à 7, dans lequel la détermination (S930) du ou des défauts de connexion comprend en outre:
la détermination (S240) que ladite au moins une de la pluralité de lignes de détection (130) identifiée comme étant dans l'état de connexion au moins temporairement défaillante, se trouve dans un état de connexion défaillante permanente sur la base des écarts de tension calculés d'une pluralité de bancs de cellules (120) associés à ladite au moins une de la pluralité de lignes de détection (130) identifiée comme étant dans l'état de connexion au moins temporairement défaillante, un temps prédéterminé, et un état de connexion faible.

9. Procédé selon la revendication 8, dans lequel la condition de connexion faible comprend
a) une première condition dans laquelle une déviation de tension d'un premier banc de cellules (120) associé à ladite au moins une de la pluralité de lignes de détection (130) identifiée comme étant dans l'état de connexion au moins temporairement défaillante est augmentée, et une déviation de tension d'un deuxième banc de cellules (120) connecté en série au premier banc de cellules (120) dans une direction de l'électrode positive par rapport au premier banc de cellules (120) est diminuée; ou
b) une deuxième condition dans laquelle une déviation de tension d'un premier banc de cellules (120) associé à ladite au moins une de la pluralité de lignes de détection (130) identifiée comme étant dans l'état de connexion au moins temporairement défaillante est diminuée et une déviation de tension d'un deuxième banc de cellules (120) connecté en série au premier banc de cellules (120) dans une direction de l'électrode positive par rapport au premier banc de cellules (120) est augmentée;
et dans lequel, pour a) et b), l'écart de tension est augmenté ou diminué par rapport à l'écart de tension d'un banc de cellules (120) n'étant pas associé à ladite au moins une de la pluralité de lignes de détection (130) identifiée comme étant dans l'état de connexion au moins temporairement défaillante.

10. Procédé selon l'une quelconque des revendications 8 ou 9, comprenant en outre:
l'activation d'une fonction de protection contre les défaillances permanentes pour ladite au moins une de la pluralité de lignes de détection (130) identifiée comme étant dans l'état de connexion défaillante permanente.

11. Procédé selon l'une quelconque des revendications précédentes, comprenant en outre:
la fourniture de données concernant une ligne de détection (130) identifiée comme comportant le ou les défauts de connexion et un banc de cellules (120) associé à la ligne de détection (130).

12. Procédé selon la revendication 11, dans lequel le banc de cellules (120) associé à la ligne de détection (130) correspond à un banc de cellules (120) positionné dans une direction vers une électrode négative entre une pluralité de bancs de cellules (120) associés à la ligne de détection (130) identifiée comme comportant le ou les défauts de connexion.

13. Au moins un support de stockage lisible par ordinateur non transitoire stockant des instructions pour exécuter le procédé selon l'une quelconque des revendications précédentes sur un ordinateur.

14. Bloc-batterie comprenant:
un système de gestion de batterie (BMS) (110);
une pluralité de bancs de cellules (120) connectées en série; et
une pluralité de lignes de détection (130) reliant la pluralité de bancs de cellules (120) au système de gestion de batterie (110),
dans lequel le système de gestion de batterie (110) est configuré pour calculer, sur la base d'une tension globale du bloc-batterie et d'une tension de chacun de la pluralité de bancs de cellules (120), des écarts de tension associés audit au moins un de la pluralité de bancs de cellules (120), et
le système de gestion de batterie (110) est en outre configuré pour déterminer, sur la base des écarts de tension calculés, un ou plusieurs défauts de connexion dans au moins une de la pluralité de lignes de détection (130) associée à la pluralité de bancs de cellules (120), et
dans lequel le système de gestion de batterie (110) est en outre configuré de telle sorte que la détermination du ou des défauts de connexion comprend:
le calcul, sur la base de l'écart de tension calculé, d'une quantité de changement d'écart de tension par unité de temps pour chacun de la pluralité de bancs de cellules (120);
la détermination, sur la base de la quantité calculée de changement dans la déviation de tension et d'un motif de changement, d'une pluralité de bancs de cellules (120) associés au ou aux défauts de connexion; et
la détermination si une ligne de détection (130) connectée entre la pluralité déterminée de bancs de cellules (120) présente un défaut de connexion.
